# EUROPÄISCHE PATENTSCHRIFT

(11) **EP 0 241 423 B1**
(45) Veröffentlichungstag und Bekanntmachung des Hinweises auf die Patenterteilung: **15.09.1993**
(21) Anmeldenummer: 87810196.3
(22) Anmeldetag: 02.04.1987
(51) Int. Cl.: G03F 7/039

(54) **Verfahren zur Herstellung positiver Abbildungen**
Process for the production of positive images
Procédé pour la fabrication d'images positives

(30) Priorität: 08.04.1986 GB 8608528
(43) Veröffentlichungstag der Anmeldung: 14.10.1987
(73) Patentinhaber: CIBA-GEIGY AG, 4002 Basel (CH)
(72) Erfinder: Demmer, Christopher George, Dr., Nr. Saffron Walden Essex CB10 1TE (GB); Irving, Edward, Dr., Cambridge CB5 0AN (GB)

(56) Entgegenhaltungen:
- EP-A- 0 139 609
- EP-A- 0 166 682
- EP-A- 0 199 672

## Beschreibung

Die vorliegende Erfindung betrifft ein Verfahren zur Herstellung von Abbildungen unter Verwendung eines positiv arbeitenden Photolackes, die in diesem Verfahren verwendeten strahlungsempfindlichen Zusammensetzungen sowie Substrate tragend die mittels besagtem Verfahren hergestellten Abbildungen.

Bei der Herstellung von Abbildungen mittels positiv arbeitender Photolacke werden besagte Lacke an den bestrahlten Stellen löslicher oder zumindest an diesen Stellen durch einen geeigneten Entwickler leichter entfernbar als an den unbestrahlten Stellen.

Falls gewünscht, werden die bestrahlten Anteile mit einem Entwickler entfernt, so dass die unbestrahlten Anteile zurückbleiben und eine positive Abbildung entsteht.

Kommerziell verfügbare Positivlacke enthalten üblicherweise neben einem geeigneten filmbildenden organischen Material ein o-Naphthochinondiazid, das sich bei Bestrahlung mit aktinischer Strahlung zersetzt und unter Abspaltung von Stickstoff eine Indencarbonsäure bildet.

Bei dem filmbildenden organischen Material handelt es sich in der Regel um ein alkalilösliches Phenol-Formaldehyd-Novolakharz. Dessen Auflösung in wässrig-alkalischer Lösung wird durch das Naphthochinondiazid inhibiert; wird dieses Diazid jedoch in den bestrahlten Bereichen zersetzt, so verringert sich seine Wirksamkeit als Lösungsinhibitor und die bestrahlten Teile einer Beschichtung werden gegenüber einem basischen Entwickler löslicher als die unbestrahlten Teile.

Die Verwendung von Chinondiaziden bringt jedoch auch Probleme mit sich, welche durch die thermische Instabilität dieser Substanzen hervorgerufen werden. Bei mässig erhöhten Temperaturen zersetzen sich diese Verbindungen, sogar unter Ausschluss von aktinischer Strahlung, und die Bildqualität nimmt in solchen Fällen ab.

Darüber hinaus benötigt man relativ grosse Mengen dieser Diazide um eine ausreichende Inhibierung der Löslichkeit zu erreichen.

Da diese Verbindungen insbesondere im kurzwellig-ultravioletten Bereich stark absorbieren, sind Zusammensetzungen enthaltend diese Diazide in besagtem Spektralbereich relativ undurchlässig und können nicht in die Tiefe, d.h. bis zur Grenzfläche zwischen Substrat und Beschichtung hinab, entwickelt werden, da die Strahlung in der Regel nicht tief in die Beschichtung vordringen kann.

In der EP-A 166 682 wird die Herstellung von positiven Abbildungen beschrieben, wobei man eine Zusammensetzung verwendet, die ein filmbildendes organisches Material enthält und eine lichtempfindliche Verbindung. Diese Substanz ist entweder ein Sulfonatester eines aromatischen Alkohols, welcher eine Carbonylgruppe in α- oder β-Stellung zum C-Atom besitzt, das die Sulfonatestergruppe trägt oder es handelt sich bei dieser Substanz um ein N-Sulfonyloxyderivat eines Amids oder Imids.

Es besteht weiterhin ein Bedarf nach Abbildungsverfahren und nach Zusammensetzungen, die in solchen Verfahren eingesetzt werden, welche das in der EP-A 166 682 beschriebene gute Eigenschaftbild besitzen aber noch empfindlicher sind und somit eine noch raschere Bildherstellung gestatten.

Es wurde jetzt gefunden, dass in Mischungen enthaltend ein filmbildendes in wässrig-alkalischen Medien lösliches Material und ein aromatisches Oximsulfonat die Auflösungsgeschwindigkeit besagten filmbildenden Materials in besagten Medien herabgesetzt ist und dass dieser Effekt durch Bestrahlung der Mischung mit aktinischer Strahlung aufgehoben werden kann.

Ferner wurde gefunden, dass nach bildmässiger Belichtung einer solchen Mischung mit aktinischer Strahlung die Löslichkeit besagter Mischung in einem wässrig-alkalischen Entwickler an den bestrahlten Stellen rasch ansteigt und dass nach der Entwicklung eine Abbildung guter Qualität entsteht.

Die vorliegende Erfindung betrifft ein Verfahren zur Herstellung von Abbildungen umfassend die Schritte
i) Belichten einer Zusammensetzung, die sich als Schicht auf einem Substrat befindet, mit einem vorbestimmten Muster aktinischer Strahlung, wobei besagte Zusammensetzung eine Mischung aus
   A) einem filmbildenden organischen Material und
   B) einer lichtempfindlichen Verbindung mit wenigstens einer Oximsulfonatgruppe der Formel I

      〉C=N-O-SO₂- (I)

      und wenigstens einer aromatischen Gruppe, enthält,
   wobei besagte Zusammensetzung in den belichteten Flächenteien eine höhere Löslichkeit in einem wässrig-alkalischen Entwickler erhält als in den unbelichteten Flächenanteilen und
ii) Entfernen besagter Zusammensetzung in den belichteten Flächenanteilen durch Behandlung mit einem wässrig-alkalischen Entwickler.

Ein weiterer Gegenstand dieser Erfindung ist eine lichtempfindliche Zusammensetzung mit der das oben definierte Verfahren durchgeführt werden kann .

Bei dieser Zusammensetzung handelt es sich also um eine Mischung enthaltend
A) ein filmbildendes organisches Material und
B) eine lichtempfindliche Verbindung, die wenigstens eine Oximsulfonatgruppe der Formel I

   〉C=N-O-SO₂- (I)

   und wenigstens einen aromatischen Rest aufweist, wobei besagte Verbindung B) keine Gruppen enthält, die im wesentlichen mit Komponente A) reagieren und wobei besagte Zusammensetzung im wesentlichen frei ist von Materialien, die in Kombination mit B) beim Erhitzen oder beim Bestrahlen mit aktinischer Strahlung polymerisieren.

In der strahlungsempfindlichen Verbindung B) sind das Kohlenstoff-sowie das Schwefelatom in der Gruppe der Formel I in der Regel jeweils an ein Kohlenstoffatom gebunden. Das Schwefelatom kann allerdings auch an ein Stickstoffatom gebunden sein. Das Kohlenstoff- oder das Schwefelatom in der Gruppe der Formel I ist an eine Gruppe gebunden, die einen aromatischen Ring enthält. Dieser Rest kann carbocyclisch-aromatisch oder heterocyclisch-aromatisch sein.

Vorzugsweise sind sowohl das Kohlenstoffatom als auch das Schwefelatom aus der Gruppe der Formel I an Gruppen enthaltend einen aromatischen Ring gebunden.

Die Verbindung B) besitzt in der Regel ein oder zwei Gruppen der Formel I.

Bevorzugte Verbindugnen B) sind Oximsulfonate der allgemeinen Formel II 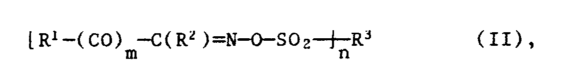
worin
- R¹: ein einwertiger aliphatischer, carbocyclischer, heterocyclischer oder araliphatischer Rest mit bis zu 20 Kohlenstoffatomen ist oder eine Cyangruppe bedeutet,
- R²: eine der unter R¹ definierten Bedeutung annimmt oder eine unsubstituierte oder substituierte Aminogruppe darstellt oder
- R¹ und R²: zusammen mit den Atomen, an die sie gebunden sind, eine carbocyclische oder heterocyclische Gruppe mit bis zu 20 Kohlenstoffatomen bilden,
- R³: eine n-wertige aliphatische, carbocyclische, heterocyclische oder araliphatische Gruppe mit bis zu 40 Kohlenstoffatomen darstellt oder eine unsubstituierte oder substituierte Aminogruppe ist,
- m: 0 oder 1 ist und
- n: 1 oder 2 bedeutet,
mit der Massgabe, dass wenigstens einer der Reste R¹, R² oder R³ einen carbocyclisch-aromatischen oder heterocyclisch-aromatischen Rest enthält.

Besonders bevorzugt werden Verbindungen der Formel II verwendet, worin
- R¹: C₁-C₁₂-Alkyl, C₁-C₄-Halogenalkyl, C₂-C₆-Alkenyl, C₅-C₁₂-Cycloalkyl, C₆-C₁₀-Aryl, das unsubstituiert oder durch ein oder mehrere Reste ausgewählt aus der Gruppe bestehend aus Halogen, C₁-C₁₆-Alkyl, C₁-C₄-Alkoxy, C₁-C₄-Alkylthio, Phenyl, Phenoxy, Phenylthio oder Nitro substituiert ist, oder Furyl, Thienyl, Tetrahydrofurfuryl, C₇-C₁₂-Aralkyl, C₁-C₈-Alkoxy, C₅-C₈-Cycloalkoxy, Phenoxy oder Cyan ist,
- R²: eine der für R¹ definierten Bedeutungen besitzt oder C₂-C₆-Alkanoyl, Benzoyl, C₂-C₅-Alkoxycarbonyl, Phenoxycarbonyl, -N(R⁴)(R⁵), Morpholino oder Piperidino ist oder
- R¹ und R²: zusammen mit den Atomen, an die sie gebunden sind, einen fünf- bis achtgliedrigen Ring bilden, an den ein oder zwei Benzogruppen kondensiert sein können,
- R⁴: Wasserstoff, C₁-C₁₂-Alkyl, Phenyl, C₂-C₆-Alkanoyl oder Benzoyl ist und
- R⁵: Wasserstoff, C₁-C₁₂-Alkyl oder Cyclohexyl bedeutet.

Die Gruppen R¹, R², R³, R⁴ und R⁵ sind als Alkyl geradkettig oder verzweigt und sind, je nach angegebener Kohlenstoffanzahl, beispielsweise Methyl, Ethyl, Propyl, Isopropyl, n-Butyl, sek.-Butyl, tert.-Butyl, n-Pentyl, Isopentyl, n-Hexyl, 2-Ethylbutyl, n-Octyl, 2-Ethylhexyl, n-Decyl oder n-Dodecyl.

R¹ und R² sind als C₁-C₄-Halogenalkyl beispielsweise Chlormethyl, Trichlormethyl, Trifluormethyl oder 2-Brompropyl.

R¹ und R² sind als Cycloalkyl beispielsweise Cyclopentyl, Cyclohexyl, Cyclooctyl oder Cyclododecyl.

R¹ und R² sind als unsubstituiertes oder substituiertes Aryl beispielsweise Phenyl, 4-Fluorphenyl, 4-Chlorphenyl, 2,4-Dichlorphenyl, 2,6-Dichlorphenyl, p-Tolyl, 2,4-Dimethylphenyl, 4-Isopropylphenyl, 4-tert.-Butylphenyl, ,4-Dodecylphenyl, 4-Methoxyphenyl, 4-Butoxyphenyl, 4-Phenoxyphenyl, 4-Biphenylyl, 3-Nitrophenyl, 1- oder 2-Naphthyl, 5-Chlor-1-naphthyl, 6-Brom-2-naphthyl, 4-Nitro-1-naphthyl oder 6-Methoxy-2-naphthyl.

R¹ ist als Furyl oder Thienyl vorzugsweise 2-Furyl oder 2-Thienyl.

R¹ und R² sind als Aralkyl beispielsweise Benzyl, 1- oder 2-Phenylethyl, 3-Phenylpropyl, 2-Phenylisopropyl, 2-Phenylhexyl oder Naphthylmethyl.

R¹ oder R² sind als Alkoxy vorzugsweise Methoxy oder Ethoxy.

R¹ oder R² sind als Cycloalkoxy vorzugsweise Cyclohexyloxy.

R² ist als Alkoxycarbonyl vorzugsweise Methoxycarbonyl oder Ethoxycarbonyl.

Bilden R¹ und R² zusammen mit den Atomen, an die sie gebunden sind, einen fünf- bis achtgliedrigen Ring, dann kann es sich dabei um einen carbocyclischen oder heterocyclischen Ring handeln. Beispiele dafür sind Cyclopentan, Cyclohexan, Cycloheptan, Pyran oder Piperidin.

An diesen Ring können Benzogruppen kondensiert sein; Beispiele dafür sind Tetrahydronaphthalin-, Dihydroanthracen-, Indan-, Chroman-, Fluoren-, Xanthen-, oder Tioxanthenringsysteme. Der Ring kann auch Carbonylgruppen enthalten; Beispiele dafür sind Cyclohexadienon-, Naphthalinon- oder Anthronsysteme.

Ganz besonders bevorzugt verwendet man Verbindungen der Formel II, worin
- n: 1 ist,
- R¹: C₁-C₆-Alkyl, C₁-C₄-Halogenalkyl, Phenyl, das unsubstituiert oder durch ein oder zwei Reste ausgewählt aus der Gruppen bestehend aus Chlor, C₁-C₄-Alkyl, C₁-C₄-Alkoxy oder Nitro substituiert ist, oder 2-Furyl, 2-Thienyl, C₁-C₄-Alkoxy oder Cyan bedeutet und
- R²: eine der für R¹ definierten Bedeutungen besitzt oder eine Dialkylamino- oder Morpholinogruppe ist, oder
- R¹ und R²: zusammen mit den Atomen, an die sie gebunden sind, einen fünf- oder sechsgliedrigen Ring bilden an den ein oder zwei Benzogruppen kondensiert sein können.

In einer ganz besonderen Vorzugsform werden Verbindungen der Formel II eingesetzt, worin
- n: 1 ist und
- R²: C₁-C₄-Alkyl, Trifluormethyl, Phenyl, Chlorphenyl, Dichlorphenyl oder Methoxyphenyl ist, R² eine der für R¹ definierten Bedeutungen besitzt, oder eine Cyangruppe ist, wobei wenigstens einer der Reste R¹ oder R² Phenyl oder substituiertes Phenyl ist oder
- R¹ und R²: zusammen mit den Kohlenstoffatomen, an welche sie gebunden sind, ein Indan-, Fluoren-, Tetrahydronaphthalin-, Anthron- oder Dihydroanthracenringsystem
bilden.

R³ in Formel II kann eine Alkyl-, Alkylen-, Cycloalkyl-, Cycloalkylen-, Aryl-, Arylen-, Aralkyl- oder Aralkylengruppe sein. Jede dieser Gruppen kann durch -O-, -S- oder -NR⁵- unterbrochen sein und jede dieser Gruppen kann unsubstituiert oder durch Halogen, Alkyl, Halogenalkyl, Aminoalkyl, Alkoxy, Aryloxy, Acyl, Acyloxy, Aracyl, Aracycloxy, Hydroxyl, Carboxyl, Alkoxycarbonyl, Alkyl-CO-NH-, Phenyl-CO-NH-, H₂N-, Alkyl-NH-, Dialkyl-N- oder Nitro substituiert sein.

R³ kann auch eine unsubstituierte oder substituierte Aminogruppe sein.

R⁵ bedeutet Wasserstoff, C₁-C₁₂-Alkyl oder Cyclohexyl.

Weitere besonders geeignete Verbindungen der Formel II sind solche, worin
- n: 1 ist und
- R³: C₁-C₁₈-Alkyl, C₆-C₁₀-Aryl, das unsubstituiert oder durch Halogen, C₁-C₁₆-Alkyl, C₁-C₄-Halogenalkyl, C₁-C₄-Aminoalkyl, C₁-C₄-Alkoxy, C₁-C₄-Alkylcarbonyl, C₁-C₄-Alkylcarbonyloxy, Benzoyl, Benzoyloxy, Hydroxyl, Carboxyl, C₁-C₄-Alkoxycarbonyl, C₁-C₄-Alkyl-CO-NH-, Phenyl-CO-NH-, H₂N-, C₁-C₄-Alkyl-NH-, Di-(C₁-C₄-Alkyl)-N- oder Nitro substituiert ist, oder C₅-C₁₂-Cycloalkyl, C₇-C₉-Aralkyl, Trifluormethyl oder Trichlormethyl bedeutet, oder worin
- n: 2 ist und
- R³: C₂-C₁₂-Alkylen, C₆-C₁₅-Arylen oder C₇-C₁₂-Aralkylen bedeutet, wobei jede dieser Gruppen durch C₁-C₁₆-Alkyl, Halogen oder Hydroxyl substituiert sein kann oder durch -O-, -S- oder -NR⁵-unterbrochen sein kann, wobei R⁵ Wasserstoff, C₁-C₁₂-Alkyl oder Cyclohexyl bedeutet.

R³ kann als Alkyl, Halogenalkyl, Alkoxy, Cycloalkyl oder Aralkyl eine der weiter oben für R¹ und R² beispielhaft gegebenen Bedeutungen annehmen.

Als substituierte und/oder unterbrochene Alkylgruppe ist R³ beispielsweise: -CH₂-CH₂-OH, -CH₂-CH₂-NH₂, -CH₂-CH(OH)-CH₂-OH, -CH₂-CH₂-O-CH₃, -CH₂-CH₂-O-CH₂-CH₂-OH, -CH₂-CH₂-S-CH₂-CH₂-OH oder -CH₂-CH₂-NH-CH₂-CH₂-NH₂.

Als unsubstituierte oder substituierte Arylgruppe kann R³ eine der für unsubstituierte oder substituierte Arylreste R¹ und R² definierten Bedeutungen annehmen. Weitere Beispiele für solche Reste R³ sind 4-Chlormethylphenyl, 4-Brommethylphenyl, 4-Aminomethylphenyl, 4-Acetylphenyl, 4-Acetyloxyphenyl, 4-Hydroxyphenyl, 2,5-Dihydroxy -naphthyl, 4-Carboxyphenyl, 3-Carboxyphenyl, 3,4-Dicarboxyphenyl, 4-Carboxymethoxyphenyl, 4-Methoxycarbonylphenyl, 3-Ethoxycarbonylphenyl, 4-Methylcarbonylphenyl, 4-Aminophenyl, 4-Methylaminophenyl oder 4-Dimethylaminophenyl.

Bei R³ als gegebenenfalls unterbrochenem oder substituiertem Alkylen handelt es sich um geradkettige oder verzweigte Reste. Beispiele dafür sind Ethylen, 1,2-Propylen, 1,3-Propylen, Tetramethylen, Hexamethylen, Octamethylen, -CH₂-CH₂-O-CH₂-CH₂-, -CH₂-CH₂-O-CH₂-CH(OH)-CH₂-, -CH₂-CH₂-S-CH₂-CH₂- oder -CH₂-CH₂-NH-CH₂-CH₂-.

Bei R³ gegebenenfalls substituiertem Arylen handelt es sich beispielsweise um 1,3-Phenylen, 1,4-Phenylen, 2-Methyl-1,3-phenylen, 5-Chlor-1,2-phenylen, 6-Hydroxy-1,3-phenylen, 4,4ʹ-Biphenylen, Oxy-4,4ʹ-biphenylen, Oxy-4,4ʹ-dihydroxy-3,3ʹ-biphenylen, 1,4-Naphthylen, 2,7-Naphthylen, 1,3-Naphthylen, 7-Chlor-1,4-naphthylen, 5,8-Dihydroxy-1,4-naphthylen, Methylenbisphenylen oder Isopropylidenbisphenylen.

Bei R³ als gegebenenfalls substituiertem Aralkylen handelt es sich beispielsweise um -p-CH₂-Ar-, -p-CH₂-CH₂-O-CH₂-Ar-, -p-CH₂-CH₂-O-Ar-, p-CH₂-Ar-CH₂- oder -p-CH₂-CH(OH)-CH₂-O-Ar-, wobei Ar ein Phenylenrest ist.

In Formel II ist n vorzugsweise 1 und R³ bedeutet C₁-C₁₂-Alkyl oder unsubstituiertes oder durch Halogen, C₁-C₁₆-Alkyl oder Hydroxyl substituiertes Phenyl; besonders bevorzugte Reste R³ sind 4-Chlorphenyl, 4-Tolyl und 4-Dodecylphenyl.

Ganz besonders bevorzugt werden Verbindungen der Formel II, worin einer der Reste R¹ und R² Phenyl oder 4-Methoxyphenyl bedeutet während der andere eine Cyangruppe ist, oder worin R¹ und R² zusammen mit dem Kohlenstoffatom, an das sie gebunden sind, ein Fluoren- oder Anthronringsystem bilden,
R³ 4-Tolyl, 4-Chlorphenyl oder 4-Dodecylphenyl ist,
m 0 ist und n 1 bedeutet.

Beispiele für ganz besonders bevorzugte Verbindungen der Formel II mit m = 0 und n = 1 sind α-(4-Toluolsulfonyloxyimino)-benzylcyanid (R¹ = Phenyl, R² = CN und R³ = 4-Tolyl), α-(4-Chlorbenzolsulfonyloxymino)-benzylcyanid (R¹ = Phenyl, R² = CN und R³ = 4-Chlorphenyl), α-(4-Dodecylbenzolsulfonyloxyimino)-benzylcyanid (R¹ = Phenyl, R² = CN und R³ = 4-Dodecylphenyl), α-[(4-Toluolsulfonyloxyimino)-4-methoxyphenyl]-acetonitril (R¹ = 4-Methoxyphenyl, R² = CN und R³ = 4-Tolyl), 9-(4-Dodecylbenzolsulfonyloxyimino)-fluoren (R¹ und R² bilden zusammen mit dem gemeinsamen Kohlenstoffatom ein Fluorensystem und R³ = 4-Dodecylphenyl) sowie α-[(4-Dodecylbenzolsulfonyloxyimino)-4-methoxyphenyl]-acetonitril (R¹ = 4-Methoxyphenyl, R² = CN, R³ = 4-Dodecylphenyl).

Die Verbindungen der Formel II können durch Umsetzung eines Oxims der Formel III mit einem Sulfonylchlorid der Formel IV hergestellt werden 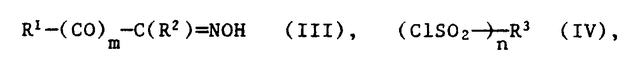
dabei haben R¹, R², R³, m und n die weiter oben definierte Bedeutung.

Die Reaktion wird in der Regel in einem inerten organischen Lösungsmittel in Gegenwart eines tertiären Amins durchgeführt.

Für den Fall, dass R³ eine funktionelle Gruppe, wie Carboxyl, Hydroxyl oder Amino, enthält, kann das Sulfonylchlorid einer entsprechend substituierten Sulfonsäure, beispielsweise eine Sulfanilsäure, Phenolsulfonsäure oder Naphthalinsulfonsäure, verwendet werden oder man führt die funktionelle Gruppe nach der Sulfonylierung des Oxims ein.

Die zur Umsetzung benötigten Oxime können in Analogie zu bekannten Verfahren hergestellt werden, beispielsweise durch Umsetzung einer entsprechenden Carbonylverbindung mit Hydroxylamin, durch Nitrosierung einer reaktiven Methylengruppe, wie beispielsweise der Methylengruppe in Benzylcyanid, mit beispielsweise Methylnitrit, oder durch Nitrosierung von aromatischen Hydroxylverbindungen.

Bevorzugte Verbindungen der Formel II und andere Verbindungen der Formel II und die Herstellung dieser Verbindungen sind in den US-Patenten No. 4 351 935 und 4 540 598 beschrieben, worin auch die Verwendung dieser Verbindungen als Härter für Aminoplaste oder phenolische Resolharze beschrieben ist.

Das Oximsulfonat B) wird vorzugsweise in Mengen von 0,05 bis 0,8, insbesondere von 0,2 bis 0,6, Gewichtsteilen, bezogen auf einen Gewichtsteil des filmbildenden organischen Materials A), eingesetzt.

Für ein bestimmtes filmbildendes organisches Material A) wird jeweils ein solches Oximsulfonat B) ausgewählt, das keine Gruppe besitzt, die im wesentlichen mit einer funktionellen Gruppe in A) reagiert.

Das filmbildende organische Material, das in einer wässrigen Base löslich ist, enthält vorzugsweise phenolische Hydroxylgruppen, Carbonsäuregruppen oder Sulfonsäuregruppen. Zu solchen Materialien zählen beispielsweise carboxyl-terminierte Polyester, beispielsweise Verbindungen, die durch Umsetzung eines zweiwertigen Alkohols mit einer Dicarbonsäure erhältlich sind.

Beispiele für bevorzugte zweiwertige Alkohole sind Ethylenglykol, Diethylenglykol und höhere Polyoxyethylenglykole; Propan-1,2-diol, Dipropylenglykol und höhere Polyoxypropylenglykole; Propan-1,3-diol; Butan-1,4-diol und Polyoxytetramethyleneglykole; Pentan-1,5-diol, Resorcit (1,3-Cyclohexandiol), Chinit (1,4-Cyclohexandiol), Bis-(4-hydroxycyclohexyl)-methan und 2,2-Bis-(4-hydroxycyclohexyl)-propan.

Beispiele für bevorzugte Dicarbonsäuren sind aliphatische Säuren, wie Bernsteinsäure, Glutarsäure, Adipinsäure, Pimelinsäure, Korksäure, Azelainsäure, Sebazinsäure oder dimerisierte Linolsäure; aromatische Säuren, wie Phthalsäure, Isophthalsäure oder Terephthalsäure und cycloaliphatische Säuren, wie Hexahydrophthalsäure.

Bevorzugte filmbildende Materialien A) sind Homo- oder Copolymere auf der Basis ethylenisch ungesättigter Phenole. Beispiele für solche Polymere sind Homopolymere von vinyl- und 1-propenylsubstituierten Phenolen, wie p-Vinylphenol oder p-(1-Propenyl)-phenol oder Copolymere dieser Phenole mit ein oder mehreren ethylenisch ungesättigten Materialien, beispielsweise mit Styrolen, Acrylestern und Vinylestern.

Bevoruzgte filmbildende Materialien umfassen Novolakharze, abgeleitet von einem Aldehyd, beispielsweise Acetalaldehyd oder Furfuraldehyd, insbesondere jedoch von Formaldehyd, mit einem Phenol, beispielsweise von Phenol, ein- oder zweifach chlorsubstituiertem Phenol, z.B. p-Chlorphenol, oder ein- oder zweifach C₁-C₉-alkylsubstituiertem Phenol, beispielsweise o-, m- oder p-Kresol, Xylenolen, p-tert.Butylphenol oder p-Nonylphenol, sowie p-Phenylphenol, Resorcin, Bis-(4-hydroxyphenyl)-methan und 2,2-Bis-(4-hydroxyphenyl)-propan.

Weitere bevorzugte filmbildende organische Materialien sind Homo-oder Copolymere auf der Basis von ethylenisch ungesättigten Carbonsäuren und Carbonsäureanhydriden. Solche Polymere umfassen Homopolymere der Acrylsäure, der Methacrylsäure und des Maleinsäureanhydrids und Copolymere dieser Monomeren mit einem oder mehreren weiteren ethylenisch ungesättigten Materialien, beispielsweise mit aliphatischen ungesättigten Verbindungen wie z.B. Ethylen, Propylen, Estern der Acryl- oder der Metahacrylsäure, Vinylestern, wie Vinylacetat, und vinylaromatischen Verbindungen, wie Styrol oder substituierten Styrolen.

Die Herstellung einer Abbildung kann durch Zugabe eines Photosensibilisators zur erfindungsgemässen Zusammensetzung beschleunigt werden; darunter versteht man im allgemeinen eine Verbindung, die bei Bestrahlung in einen angeregten Zustand übergeführt wird und dann die Anregungsenergie auf das nicht angeregte aromatische Oximsulfonat B) überträgt.

Zu solchen Photosensibilisatoren zählen beispielsweise kondensierte aromatische Kohlenwasserstoffe und deren substituierte Derivate, aromatische Carbonylverbindungen, aromatische Nitroverbindungen und kationische und basische Farbstoffe.

Ausgewählte Klassen geeigneter Photoinitiatoren sind Anthracene, Fluoranthene, Pyrene, Anthrone, Thioxanthone, wie 2-Methyl oder 2-Chlorthioxanthon, und Benzophenone, bevorzugt Bis-(dialkylamino)-benzophenone wie 4,4ʹ-Bis-(dimethylamino)-benzophenon (Michlers Keton).

Ferner kann die erfindungsgemässe Zusammensetzung auch noch einen Farbstoff, beispielsweise Kristallviolett, enthalten, um die Abbildung besser sichtbar zu machen.

Zur Durchführung des erfindungsgemässen Abbildungsverfahrens wird eine Schicht der Zusammensetzung, aus der die Abbildung hergestellt worden soll, aus der Lösung auf ein Substrat übertragen; Beispiele für geeignete Lösungsmittel sind 2-Ethoxyethanol, 2-Ethoxyethylacetat, Ethylmethylketon, N-Methylpyrrolidon, Dimethylformamid, Dioxan oder Mischungen dieser Lösungsmittel.

Die Beschichtung erfolgt in an sich bekannter Weise, beispielsweise durch Tauchen, Aufschleudern, Aufsprühen oder Aufrollen.

Anschliessend wird das Lösungsmittel verdampfen gelassen, beispielsweise durch Trocknen an der Luft oder durch Erhitzen auf eine Temperatur, die unter derjenigen liegt, bei der mögliche hitzehärtbare Komponenten ausgehärtet werden. Der Träger besteht üblicherweise aus Metall, beispielsweise aus Kupfer oder Aluminium, oder aus Silizium, dessen Oxiden oder Nitriden, aus synthetischen Harzen oder Kunststoffen, beispielsweise aus einem Polyesterfilm, einem Polyamidfilm oder Polyolefinfilm, sowie aus Papier oder Glas; nach dem Trocknen ist dieses Trägermaterial in der Regel mit einem Film von 1-250 Mikrometern Dicke beschichtet.

Die Belichtung der Schicht mit einem vorbestimmten Muster aktinischer Strahlung kann mittels einer bildtragenden Vorlage erfolgen, die im wesentlichen durchlässige und undurchlässige Flächen aufweist; die Belichtung kann aber auch mittels eines Laserstrahls erfolgen, der computer-gesteuert über die Oberfläche bewegt wird.

In der Regel verwendet man aktinische Strahlung der Wellenlänge von 200 bis 600 nm. Geeignete Strahlungsquellen sind beispielsweise Kohlelichtbögen, Quecksilberdampflampen, Leuchtstoffröhren mit ultraviolettes Licht emittierenden Phosphoren, Argon- und Xenon-Glimmlampen, Wolframlampen und photographische Flutlichtlampen; von diesen Lichtquellen eignen sich insbesondere Quecksilberdampflampen und Metallhalogenidlampen.

Die Belichtungszeit hängt von mehreren Faktoren ab. So spielen beispielsweise die Art und Weise der eingesetzten Zusammensetzung, deren Schichtdicke und die Art der verwendeten Lichtquellen und deren Abstand von der Schicht eine Rolle. Die Belichtungszeit bewegt sich in der Regel im Bereich von 10 Sekunden bis 4 Minuten und eine geeignete Belichtungsdauer kann vom Fachmann mittels Routineexperimenten ermittelt werden.

Nach der bildmässigen Belichtung wird die Schicht der erfindungsgemässen Zusammensetzung mit einem Entwickler behandelt, um die belichteten Flächenanteile zu entfernen. Es verbleiben also die nichtbelichteten Flächenanteile auf dem Substrat. Der Entwickler löst die belichteten Anteile auf oder bewirkt bei leichten Bürsten oder leichter Bewegung eine bessere Entfernbarkeit derselben.

Der wässrig-basische Entwickler kann eine wässrige Lösung einer starken Base, beispielsweise von Triethylamin, sein, bevorzugt werden wässrig-alkalische Lösungen enthaltend Natriumhydroxid, Natriumcarbonat oder Dinatriumhydrogenophosphat.

Um die Entwicklungsdauer zu verkürzen empfiehlt es sich, eine kleine Menge, in der Regel 5-15 Vol.%, eines wasser-mischbaren, niedrigen aliphatischen Alkohols, beispielsweise Methanol, zuzusetzen.

Nach Belichtung und Entwicklung kann das Substrat einem Aetzprozess unterworfen werden, um beispielsweise Metall aus den freigelegten Anteilen der Oberfläche zu entfernen und somit eine gedruckte Schaltung zu bilden oder um die Bildtiefe und somit die Differenzierung zu vergrössern; dabei wirkt der in den unbelichteten Anteilen verbliebene Teil der Beschichtung als Schutzschicht für das darunterliegende Substrat. Geeignete Aetzprozesse sind dem Fachmann bekannt; für Kupfersubstrate benutzt man beispielsweise Eisen-(III)-chlorid- oder Ammoniumpersulfatlösungen.

Die Substratoberfläche kann dann gegebenenfalls ganzflächig für eine längere Zeitdauer nachbelichtet werden, um die verbliebene Beschichtung gegenüber basischen Entwicklerlösungen löslicher zu machen und eine einfachere Entfernung der Beschichtung zu gestatten.

Eine weitere Nachentwicklungsstufe bei metallischen Substraten umfasst das Plattieren mit einem Metall, beispielsweise mit Kupfer, Zinn, Blei oder Nickel, das anschliessende Entfernen der Polymerschicht in den nichtbelichteten Bereichen, beispielsweise durch ganzflächige Belichtung und anschliessendes Entwickeln; gefolgt vom Wegätzen des Metalls von der freigelegten Oberfläche.

Mit dem erfindungsgemässen Verfahren können beispielsweise Druckplatten oder gedruckte, integrierte oder Hybridschaltkreise hergestellt werden.

Die folgenden Beispiele illustrieren die Erfindung. Mengenangaben bedeuten Gewichtsteile, falls nicht anders definiert.

### Herstellung von α-(4-Toluolsulfonyloxyimino)-benzylcyanid

α-Hydroxyiminobenzylcyanid wird in an sich bekannter Weise durch Umsetzung von Benzylcyanid mit Methylnitrit in einem Gemisch aus Methanol und Natriummethanolat hergestellt.
14,6 g (0,1 Mol) α-(Hydroxyiminobenzylcyanid werden in 50 g Tetrahydrofuran gelöst und diese Lösung wird auf -8°C gekühlt. Dazu gibt man 15,2 g Triethylamin und anschliessend 19,1 g (0,1 Mol) 4-Toluolsulfonylchlorid in 50 ml Tetrahydrofuran. Die Zugabegeschwindigkeit wird so eingestellt, dass die Reaktionstemperatur unterhalb von 0°C bleibt.
Unter fortgesetztem Rühren wird die Reaktionstemperatur dann auf Raumtemperatur ansteigen gelassen (ca. 2 Stunden) und die Reaktionsmischung dann in 1 Liter kaltes Wassser, das 13 ml konz. Salzsäure enthält, gegossen. Man erhält einen weissen, kristallinen Niederschlag, der aus Ethanol umkristallisiert wird.

Das Produkt besitzt einen Schmelzpunkt von 133-134°C.
Das IR-Spektrum (gemessen zwischen KBr Scheiben) zeigt Absorptionsmaxima bei 1600, 1390, 1300, 1190, 1180, 1160, 1090, 910, 830, 810, 770, 730, 680, 670 und 640 cm⁻¹.
Das ¹H-NMR Spektrum zeigt ein aromatisches Multiplettsignal bei 7,5-8,2 ppm und ein Singulettsignal (-CH₃) bei 2,4 ppm.

Die anderen Oximsulfonate, die in den folgenden Beispielen eingesetzt werden, enthält man aus den entsprechenden Oximen nach analogen Verfahren.

Beispiel 1: Man stellt eine Lösung aus 4 Teilen eines gemischten Kresol-Novalaks (Erweichungspunkt: 136°C), 1 Teil α-(4-Toluolsulfonyloxyiminio)-benzylcyanid, 2 Teilen Dimethylformamid und 8 Teilen Dioxan her. Mit dieser Mischung wird ein gereinigtes kupferkaschiertes Laminat beschichtet. Nach fünfminütigem Trocknen bei 90°C erhält man eine Beschichtung von 7 µm Dicke.

Diese Schicht wird mittels einer 5000 W Metallhalogenidlampe durch ein Negativ belichtet (Abstand: 75 cm; Belichtungszeit: 15 Sekunden).

Nach Entwicklung mit 1,5 %iger wässriger Natronlauge erhält man innerhalb von 30 Sekunden eine Abbildung guter Qualität.

Beispiel 2: Man stellt eine Lösung aus 4 Teilen eines gemischten Kresol-Novolaks (Erweichungspunkt: 136°C), 1 Teil α-(4-Chlorbenzolsulfonyloxyiminio)-benzylcyanid, 2 Teilen Dimethylformamid und 8 Teilen Dioxan her. Mit dieser Mischung wird ein gereinigtes kupferkaschiertes Laminat beschichtet und 5 Minuten bei 90°C getrocknet. Man erhält eine Beschichtung von 6 µm Dicke.

Diese Schicht wird mittels einer 5000 W Metallhalogenidlampe durch ein Negativ belichtet (Abstand: 75 cm; Belichtungsdauer: 30 Sekunden).

Nach Entwicklung mit 1,5 %iger Natronlauge erhält man innerhalb von 30 Sekunden eine Abbildung guter Qualität.

Beispiel 3: Man löst 4 Teile eines gemischten Kresol-Novolaks (Erweichungspunkt 136°C) und 1 Teil α-(4-Dodecylbenzolsulfonyloxyimino)-benzylcyanid in 8 Teilen eines Gemisches aus 2-Ethoxyethanol, 2-Ethoxyethylacetat und Methylethylketon (Volumenverhältnis 2:2:1) auf. Mit der Mischung beschicht man ein gereinigtes kupferkaschiertes Laminat und trocknet 5 Minuten lang bei 90°C. Es entsteht eine 5 µm dicke Beschichtung.

Die Probe wird mittels einer 5000 W Metallhalogenidlampe 30 Sekunden lang aus einer Entfernung von 75 cm durch ein Negativ belichtet. Nach 30 Sekunden Entwickeln in 2 %iger Natronlauge erhält man eine Abbildung guter Qualität.

Beispiel 4: Man löst 4 Teile eines gemischten Kresol-Novolaks (Erweichungspunkt: 136°C) und 1 Teil α-(4-Toluolsulfonyloxyimino)-4-methoxyphenylacetonitril in 2 Teilen Dimethylformamid und 8 Teilen Dioxan. Mit der Mischung beschichtet man ein gereinigtes kupferkaschiertes Laminat und trocknet 5 Minuten lang bei 90°C. Es entsteht eine 5 µm dicke Beschichtung.

Die Probe wird mittels einer 5000 W Metallhalogenidlampe 10 Sekunden lang aus einer Entfernung von 75 cm durch ein Negativ belichtet. Nach 45 Sekunden Entwickeln mit 2 %iger Natronlauge entsteht eine Abbildung guter Qualität.

Beispiel 5: Man löst 4 Teile eines gemischten Kresol-Novolaks (Erweichungspunkt: 136°C) und 1 Teil 9-(4-Dodecylbenzolsulfonyloxyimino)-fluoren in 8 Teilen eines Gemisches aus 2-Ethoxyethanol, 2-Ethoxyethalacetat, Ethylmethylketon und DMF (Volumenverhältnis 2:2:1:1) auf. Mit der Mischung beschichtet man ein gereinigtes kupferkaschiertes Laminat und trocknet 5 Minuten lang bei 90°C. Es entsteht eine 5 µm dicke Beschichtung.

Die Probe wird mittels einer 5000 W Metallhalogenidlampe 30 Sekunden lang aus einer Entfernung von 75 cm durch ein Negativ belichtet. Nach 2 Minuten Entwickeln mit 1,5 %iger Natronlauge erhält man eine Abbildung guter Qualität.

Beispiel 6: Man löst 4 Teile eines Acrylcopolymeren (hergestellt durch Copolymerisation von Methylmethacrylat, 2-Hydroxyethylmethacrylat und Methacrylsäure im Gewichtsverhältnis 50:40:10, Säurezahl: 1,0 Aequ./kg) und 1 Teil α-[4-(Toluolsulfonyloxyimino)-4-methyoxyphenyl]-acetonitril in 8 Teilen Dioxan und 2 Teilen DMF.

Mit dieser Lösung beschichtet man gereinigtes kupferkaschiertes Laminat und trocknet 5 Minuten lang bei 90°C. Man erhält eine Beschichtung von 5 µm Dicke. Die Probe wird mittels einer 5000 W Metallhalogenidlampe 30 Sekunden lang aus einer Entfernung von 75 cm durch ein Negativ bestrahlt. Nach 20 Sekunden Entwicklung mit 2 %iger Natronlauge und anschliessendem Spülen mit Wasser erhält man eine Abbildung guter Qualität.

Beispiel 7: Man löst 4 Teile eines tert.-Butylphenol-Phenol-Novolaks (molares Verhältnis 30:70; Erweichungspunkt: 125°C) und 1 Teil α-[4-(Toluolsulfonyloxyimino)-4-methoxyphenyl]-acetonitril in 8 Teilen Dioxan und 2 Teilen DMF.

Mit dieser Lösung beschichtet man ein gereinigtes kupferkaschiertes Laminat und trocknet 5 Minuten lang bei 90°C. Es entsteht eine Beschichtung von 7 µm Dicke. Die Probe wird mittels einer 5000 W Metallhalogenidlampe 30 Sekunden lang im Abstand von 75 cm durch ein Negativ bestrahlt. Nach 15 Sekunden Entwicklung mit 1 %iger Natronlauge erhält man eine Abbildung guter Qualität.

Beispiel 8: Man stellt eine Lösung aus 4 Teilen Poly-(p-vinylphenol) mit einem mittleren Molekulargewicht (Gewichtsmittel) von 10'000 (Resin M Grade S-4® der Fa. Maruzen Oil Co. Ltd, Tokyo, Japan) und 1 Teil α-(4-Toluolsulfonyloxyimino)-benzylcyanid in 2 Teilen DMF und 8 Teilen Dioxan her.
Mit dieser Mischung beschichtet man ein gereinigtes kupferkaschiertes Laminat und trocknet 5 Minuten lang bei 90°C. Es entsteht eine Beschichtung von 10 µm Dicke. Die Probe wird mittels einer 5000 W Metallhalogenidlampe 30 Sekunden lang aus einer Entfernung von 75 cm durch ein Negativ belichtet. Nach 30 Sekunden Entwickeln mit 0,5 %iger wässriger Natronlauge erhält man eine Abbildung guter Qualität.

Beispiel 9: Man stellt eine Lösung aus 4 Teilen eines gemischten Kresol-Novolaks (Erweichungspunkt: 136°C) und 1 Teil α[(4-Dodecylbenzolsulfonyloxyimino)-4-methoxyphenyl]-acetonitril in 8 Teilen einer Lösungsmittelmischung aus 2-Ethoxyethanol, 2-Ethoxyethylacetat und Methylethylketon (Volumenverhältnis 2:2:1) her.

Mit dieser Mischung beschichtet man ein gereinigtes kupferkaschiertes Laminat und trocknet 5 Minuten lang bei 90°C. Es entsteht eine 10 µm dicke Beschichtung.

Die Probe wird mittels einer 5000 W Metallhalogenidlampe 30 Sekunden lang aus einer Entfernung von 75 cm durch ein Negativ bestrahlt. Nach 20 Sekunden Entwickeln mit 2 %iger Natronlauge entsteht eine Abbildung guter Qualität.

## Patentansprüche

1. Verfahren zur Herstellung von Abbildungen umfassend die Schritte
i) Belichten einer Zusammensetzung, die sich als Schicht auf einem Substrat befindet, mit einem vorbestimmten Muster aktinischer Strahlung, wobei besagte Zusammensetzung eine Mischung aus
A) einem filmbildenden organischen Material und
B) einer lichtempfindlichen Verbindung mit wenigstens einer Oximsulfonatgruppe der Formel I
〉C=N-O-SO₂- (I)
und wenigstens einer aromatischen Gruppe, enthält,
wobei besagte Zusammensetzung in den belichteten Flächenteilen eine höhere Löslichkeit in einem wässrig-alkalischen Entwickler erhält als in den unbelichteten Flächenanteilen und
ii) Entfernen besagter Zusammensetzung in den belichteten Flächenanteilen durch Behandlung mit einem wässrig-alkalischen Entwickler.

2. Verfahren gemäss Anspruch 1, worin das Kohlenstoffatom oder das Schwefelatom der Gruppe der Formel I an eine Gruppe enthaltend einen aromatischen Ring gebunden ist oder worin das Kohlenstoffatom und das Schwefelatom der Gruppe der Formel I jeweils an eine Gruppe enthaltend einen aromatischen Ring gebunden sind.

3. Verfahren gemäss Anspruch 1, worin Verbindung B) die allgemeine Formel II besitzt 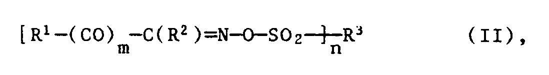 worin
R¹ ein einwertiger aliphatischer, carbocyclischer, heterocyclischer oder araliphatischer Rest mit bis zu 20 Kohlenstoffatomen oder eine Cyangruppe ist,
R² eine der unter R¹ definerten Bedeutungen annimmt oder eine unsubstituierte oder substituierte Aminogruppe darstellt oder
R¹ und R² zusammen mit den Atomen, an die sie gebunden sind, eine carbocyclische oder heterocyclische Gruppe mit bis zu 20 Kohlenstoffatomen bilden,
R³ eine n-wertige aliphatische, carbocyclische, heterocyclische oder araliphatische Gruppe mit bis zu 40 Kohlenstoffatomen darstellt oder eine unsubstituierte oder substituierte Aminogruppe ist,
m 0 oder 1 ist und
n 1 oder 2 bedeutet,
mit der Massgabe, dass wenigstens einer der Reste R¹, R² oder R³ einen carbocyclisch-aromatischen oder heterocyclisch-aromatischen Rest enthält.

4. Verfahren gemäss Anspruch 3, worin
R¹ C₁-C₁₂-Alkyl, C₁-C₄-Halogenalkyl, C₂-C₆-Alkenyl, C₅-C₁₂-Cycloalkyl, C₆-C₁₆-Aryl, das unsubstituiert oder durch ein oder mehrere Reste ausgewählt aus der Gruppe bestehend aus Halogen, C₁-C₁₆-Alkyl, C₁-C₄-Alkoxy, C₁-C₄-Alkylthio, Phenyl, Phenoxy, Phenylthio oder Nitro substituiert ist, oder Furyl, Thienyl, Tetrahydrofurfuryl, C₇-C₁₂-Aralkyl, C₁-C₈-Alkoxy, C₅-C₈-Cycloalkoxy, Phenoxy oder Cyan ist,
R² eine der für R¹ definierten Bedeutungen besitzt oder C₂-C₆-Alkanoyl, Benzoyl, C₂-C₅-Alkoxycarbonyl, Phenoxycarbonyl, -N(R⁴)(R⁵), Morpholino oder Piperidino ist oder
R¹ und R² zusammen mit den Atomen, an die sie gebunden sind, einen fünf- bis achtgliedrigen Ring bilden, an den ein oder zwei Benzogruppen kondensiert sein können,
R⁴ Wasserstoff, C₁-C₁₂-Alkyl, Phenyl, C₂-C₆-Alkanoyl oder Benzoyl ist und
R⁵ Wasserstoff, C₁-C₁₂-Alkyl oder Cyclohexyl bedeutet.

5. Verfahren gemäss Anspruch 4, worin
n 1 ist,
R¹ C₁-C₆-Alkyl, C₁-C₄-Halogenalkyl, Phenyl, das unsubstituiert oder durch ein oder zwei Reste ausgewählt aus der Gruppe bestehend aus Chlor, C₁-C₄-Alkyl, C₁-C₄-Alkoxy oder Nitro substituiert ist, oder 2-Furyl, 2-Thienyl, C₁-C₄-Alkoxy oder Cyan bedeutet und
R² eine der für R¹ definierten Bedeutungen besitzt oder eine Dialkylamin- oder Morpholinogruppe ist, oder
R¹ und R² zusammen mit den Atomen, an die sie gebunden sind, einen fünf- oder sechsgliedrigen Ring bilden, an den ein oder zwei Benzogruppen kondensiert sein können.

6. Verfahren gemäss Anspruch 5, worin
R¹ C₁-C₄-Alkyl, Trifluormethyl, Phenyl, Chlorphenyl, Dichlorphenyl oder Methoxyphenyl ist,
R² eine der für R¹ definierten Bedeutungen besitzt, oder eine Cyangruppe ist, wobei wenigstens einer der Reste R¹ oder R² Phenyl oder substituiertes Phenyl ist oder
R¹ und R² zusammen mit den Kohlenstoffatomen an welche sie gebunden sind ein Indan-, Fluoren-, Tetrahydronaphthalin-, Anthron- oder Dihydroanthracenringsystem
bilden.

7. Verfahren gemäss Anspruch 3, worin
n 1 ist und
R³ C₁-C₁₈-Alkyl, C₆-C₁₀-Aryl, das unsubstituiert oder durch Halogen, C₁-C₁₆-Alkyl, C₁-C₄-Halogenalkyl, C₁-C₄-Aminoalkyl, C₁-C₄-Alkoxy, C₁-C₄-Alkylcarbonyl, C₁-C₄-Alkylcarbonyloxy, Benzoyl, Benzoyloxy, Hydroxy, Carboxyl, C₁-C₄-Alkoxycarbonyl, C₁-C₄-Alkyl-CONH-, Phenyl-CONH-, H₂N-, C₁-C₄-Alkyl-NH-, Di-(C₁-C₄-alkyl)-N- oder Nitro substituiert ist oder C₅-C₁₂-Cycloalkyl, C₇-C₉-Aralkyl, Trifluormethyl oder Trichlormethyl bedeutet, oder worin
n 2 ist und
R³ C₂-C₁₂-Alkylen, C₆-C₁₅-Arylen oder C₇-C₁₂-Aralkylen bedeutet,
wobei jede dieser Gruppen durch C₁-C₁₆-Alkyl, Halogen oder Hydroxyl substituiert sein kann oder durch -O-, -S- oder -NR⁵- unterbrochen sein kann, wobei R⁵ Wasserstoff, C₁-C₁₂-Alkyl oder Cyclohexyl bedeutet.

8. Verfahren gemäss Anspruch 7, worin n 1 bedeutet und R³ C₁-C₁₂-Alkyl ist oder Phenyl, das unsubstituiert oder durch Halogen, C₁-C₁₆-Alkyl oder Hydroxyl substituiert ist, bedeutet.

9. Verfahren gemäss Anspruch 3, worin einer der Reste R¹ oder R² Phenyl oder 4-Methoxyphenyl bedeutet, während der andere eine Cyangruppe ist, oder worin R¹ und R² zusammen mit dem Kohlenstoffatom, an das sie gebunden sind, ein Fluoren- oder Anthronringsystem bilden, R³ 4-Tolyl, 4-Chlorphenyl oder 4-Dodecylphenyl ist, m 0 ist und n 1 bedeutet.

10. Verfahren gemäss Anspruch 1, worin das filmbildende organische Material A) eine phenolische Hydroxylgruppe, eine Carboxylgruppe oder eine Sulfonsäuregruppe enthält.

11. Verfahren gemäss Anspruch 10, worin das filmbildende, organische Material A) ein Polymer auf Basis eines ethylenisch ungesättigten Phenols, ein Novolakharz oder ein Homopolymer oder Copolymer auf Basis einer ethylenisch ungesättigten Carbonsäure oder eines ethylenisch ungesättigten Carbonsäureanhydrids ist.

12. Zusammensetzung, die sich zur Durchführung eines Verfahrens gemäss Anspruch 1 eignet, enthaltend eine Mischung aus
A) einem filmbildenden organischen Material und
B) einer lichtempfindlichen Verbindung mit wenigstens einer Oximsulfonatgruppe der Formel I und wenigstens einem aromatischen Rest gemäss Anspruch 1 , wobei besagte Verbindung B) keine Gruppen enthält, die im wesentlichen mit Komponente A) reagieren und wobei besagte Zusammensetzung im wesentlichen frei ist von Materialien, die in Kombination mit B) beim Erhitzen oder beim Bestrahlen mit aktinischer Strahlung polymerisieren.

13. Zusammensetzung gemäss Anspruch 12, worin B) eine lichtempfindliche Verbindung gemäss Anspruch 2 ist und A) ein filmbildendes Material gemäss Anspruch 10 ist.

14. Zusammensetzung gemäss Anspruch 12, worin das Oximsulfonat B) in Mengen von 0,05 bis 0,8 Gewichtsteilen, bezogen auf einen Gewichtsteil des filmbildenden organischen Materials A), eingesetzt wird.

## Claims

1. A process for the production of images, comprising the steps of
(i) exposing a composition which is present as a layer on a substrate to actinic radiation in a predetermined pattern, said composition comprising a mixture of
A) a film-forming organic material and
B) a photosensitive compound having at least one oxime sulfonate group of formula I
〉C=N-O-SO₂- (I)
and at least one aromatic group,
giving said composition greater solubility in an aqueous alkaline developer in the exposed areas than in the unexposed areas, and
(ii) removing said composition in the exposed areas by treatment with an aqueous-alkaline developer.

2. A process according to claim 1, in which the carbon atom or the sulfur atom in the group of formula I is attached to a group containing an aromatic ring or in which the carbon atom and the sulfur atom in the group of formula I are each attached to a group containing an aromatic ring.

3. A process according to claim 1, in which compound B) has the general formula II 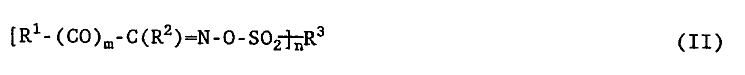 in which
R¹ is a monovalent aliphatic, carbocyclic, heterocyclic or araliphatic radical having up to 20 carbon atoms, or a cyano group,
R² is as defined for R¹ or is an unsubstituted or substituted amino group, or
R¹ and R², together with the atoms to which they are attached, form a carbocyclic or heterocyclic group having up to 20 carbon atoms,
R³ is an n-valent aliphatic, carbocyclic, heterocyclic or araliphatic group having up to 40 carbon atoms or an unsubstituted or substituted amino group,
m is 0 or 1, and
n is 1 or 2,
with the proviso that at least one of the radicals R¹, R² and R³ contains a carbocyclic aromatic or heterocyclic aromatic radical.

4. A process according to claim 3, in which
R¹ is C₁-C₁₂alkyl, C₁-C₄haloalkyl, C₂-C₆alkenyl, C₅-C₁₂cycloalkyl, C₆-C₁₀aryl which is unsubstituted or substituted by one or more radicals selected from the group consisting of halogen, C₁-C₁₆alkyl, C₁-C₄alkoxy, C₁-C₄alkylthio, phenyl, phenoxy, phenylthio or nitro, or is furyl, thienyl, tetrahydrofurfuryl, C₇-C₁₂aralkyl, C₁-C₈alkoxy, C₅-C₈cycloalkoxy, phenoxy or cyano,
R² is as defined for R¹ or is C₂-C6alkanoyl, benzoyl, C₂-C₅alkoxycarbonyl, phenoxycarbonyl, -N(R⁴)(R⁵), morpholino or piperidino, or
R¹ and R², together with the atoms to which they are attached, form a five- to eight-membered ring to which one or two benzo groups may be fused.
R⁴ is hydrogen, C₁-C₁₂alkyl, phenyl, C₂-C₆-alkanoyl or benzoyl, and
R⁵ is hydrogen, C₁-C₁₂alkyl or cyclohexyl.

5. A process according to claim 4, in which
n is 1,
R¹ is C₁-C₆alkyl, C₁-C₄haloalkyl, phenyl which is unsubstituted or substituted by one or two radicals selected from the group consisting of chlorine, C₁-C₄alkyl, C₁-C₄alkoxy or nitro, or is 2-furyl, 2-thienyl, C₁-C₄alkoxy or cyano, and
R² is as defined for R¹ or is a dialkylamino or morpholino group, or
R¹ and R², together with the atoms to which they are attached, form a five- or six-membered ring to which one or two benzo groups may be fused.

6. A process according to claim 5, in which
R¹ is C₁-C₄alkyl, trifluoromethyl, phenyl, chlorophenyl, dichlorophenyl or methoxyphenyl,
R² is as defined for R¹ or is a cyano group, at least one of the radicals R¹ or R² being phenyl or substituted phenyl, or
R¹ and R², together with the carbon atoms to which they are attached, form an indane, fluorene, tetrahydronaphthalene, anthrone or dihydroanthralene ring system.

7. A process according to claim 3, in which
n is 1 and
R³ is C₁-C₁₈alkyl, C₆-C₁₀aryl which is unsubstituted or substituted by halogen, C₁-C₁₆alkyl, C₁-C₄haloalkyl, C₁-C₄aminoalkyl, C₁-C₄alkoxy, C₁-C₄alkylcarbonyl, C₁-C₄alkylcarbonyloxy, benzoyl, benzoyloxy, hydroxyl, carboxyl, C₁-C₄alkoxycarbonyl, C₁-C₄alkyl-CONH-, phenyl-CONH-, H₂N-, C₁-C₄alkyl-NH-, di(C₁-C₄-alkyl)-N- or nitro, or is C₅-C₁₂cycloalkyl, C₇-C₉aralkyl, trifluoromethyl or trichloromethyl, or
in which n is 2 and
R³ is C₂-C₁₂alkylene, C₆-C₁₅arylene or C₇-C₁₂aralkylene, any of which groups may be substituted by C₁-C₁₆alkyl, halogen or hydroxyl or interrupted by -O-, -S- or -NR⁵-, where R⁵ is hydrogen, C₁-C₁₂alkyl or cyclohexyl.

8. A process according to claim 7, in which n is 1 and R³ is C₁-C₁₂alkyl or is phenyl which is unsubstituted or substituted by halogen, C₁-C₁₆alkyl or hydroxyl.

9. A process according to claim 3, in which one of the radicals R¹ and R² is phenyl or 4-methoxyphenyl while the other is a cyano group, or in which R¹ and R², together with the carbon atom to which they are attached, form a fluorene or anthrone ring system,
R³ is 4-tolyl, 4-chlorophenyl or 4-dodecylphenyl,
m is 0 and
n is 1.

10. A process according to claim 1, in which the film-forming organic material A) contains a phenolic hydroxyl group, a carboxyl group or a sulfonic acid group.

11. A process according to claim 10, in which the film-forming organic material A) is a polymer based on an ethylenically unsaturated phenol, a novolak resin, or a homopolymer or copolymer based on an ethylenically unsaturated carboxylic acid or an ethylenically unsaturated carboxylic acid anhydride.

12. A composition suitable for carrying out a process according to claim 1, comprising a mixture of
A) a film-forming organic material and
B) a photosensitive compound having at least one oxime sulfonate group of formula I and at least one aromatic radical according to claim 1, said compound B) containing no groups which react substantially with component A), and said composition being substantially free from materials which, in combination with B), are polymerized on heating or on exposure to actinic radiation.

13. A composition according to claim 12, in which B) is a photosensitive compound as in claim 2 and A) is a film-forming material as in claim 10.

14. A composition according to claim 12, in which the oxime sulfonate B) is employed in amounts of from 0.05 to 0.8 parts by weight, based on one part by weight of the film-forming organic material A).

## Revendications

1. Procédé de production d'images comprenant les étapes suivantes :
i) éclairement d'une composition qui se trouve sous forme de couche sur un substrat, avec un type déterminé de rayonnement actinique, cette composition contenant un mélange
A) d'une matière organique filmogène et
B) d'un composé photosensible ayant au moins un groupe sulfonate d'oxime répondant à la formule I :
〉C=N-O-SO₂- (I)
et au moins un groupe aromatique, cette composition acquérant dans les parties éclairées de la surface une solubilité plus élevée dans un révélateur aqueux-alcalin que dans les parties de la surface non éclairées, et
ii) élimination de cette composition dans les parties de la surface éclairées par traitement avec un révélateur aqueux-alcalin.

2. Procédé selon la revendication 1, dans lequel l'atome de carbone ou l'atome de soufre du groupe répondant à la formule I est lié à un groupe contenant un cycle aromatique ou dans lequel l'atome de carbone et l'atome de soufre du groupe répondant à la formule I sont liés chacun à un groupe contenant un cycle aromatique.

3. Procédé selon la revendication 1, dans lequel le composé B) répond à la formule générale II 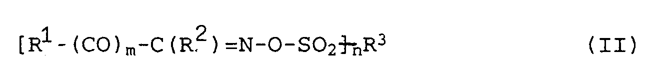 dans laquelle
R¹ est un radical alphatique, carbocyclique, hétérocyclique ou araliphatique monovalent ayant jusqu'à 20 atomes de carbone ou un groupe cyanique,
R² prend une des significations définies pour R¹ ou représente un groupe amino non substitué ou substitué, ou bien
R¹ et R² forment avec les atomes d'azote auxquels ils sont liés un groupe carbocyclique ou hétérocyclique ayant jusqu'à 20 atomes de carbone,
R³ est un groupe aliphatique, carbocyclique, hétérocyclique ou araliphatique n-valent, ayant jusqu'à 40 atomes de carbone ou un groupe amino non substitué ou substitué,
m est 0 ou 1 et
n est 1 ou 2,
sous réserve qu'au moins un des radicaux R¹, R² ou R³ contient un radical carbocyclique-aromatique ou hétérocyclique-aromatique.

4. Procédé selon la revendication 3, dans lequel
R¹ est un groupe alkyle en C₁-C₁₂, halogénoalkyle en C₁-C₄, alcényle en C₂-C₆, cycloalkyle en C₅-C₁₂, aryle en C₆-C₁₀ qui est non substitué ou substitué par un ou plusieurs radicaux choisis parmi les atomes d'halogène, les groupes alkyle en C₁-C₁₆, alcoxy en C₁-C₄, alkylthio en C₁-C₄, phényle, phénoxy, phénylthio ou nitro, ou est un groupe furyle, thiényle, tétrahydrofurfuryle, aralkyle en c₇-c₁₂, alcoxy en C₁-C₈, cycloalcoxy en C₅-C₈, phénoxy ou cyano,
R² possède une des significations définies pour R¹^{,} ou est un groupe alcanoyle en C₂-C₆, benzoyle, (alcoxy en C₂-C₅)carbonyle, phénoxycarbonyle, -N(R⁴)(R⁵), morpholino ou pipéridino, ou bien
R¹ et R² forment avec les atomes auxquels ils sont liés un cycle à 5 à 8 maillons, sur lequel peuvent être condensés un ou deux groupes benzo,
R⁴ est un atome d'hydrogène, un groupe alkyle en C₁-C₁₂, phényle, alcanoyle en C₂-C₆ ou benzoyle et
R⁵ est un atome d'hydrogène, un groupe alkyle en C₁-C₁₂ ou cyclohexyle.

5. Procédé selon la revendication 4, dans lequel
n est 1,
R¹ est un groupe alkyle en C₁-C₆, halogénoalkyle en C₁-C₄, phényle qui peut être non substitué ou substitué par 1 ou 2 radicaux choisis parmi les atomes de chlore, les groupes alkyle en C₁-C₄, alcoxy en C₁-C₄ ou nitro, ou un groupe 2-furyle, 2-thiényle, alcoxy en C₁-C₄ ou cyano et
R² possède une des significations définies pour R¹^{,} ou est un groupe dialkylamino ou morpholino, ou bien
R¹ et R² forment avec les atomes auxquels ils sont liés un cycle à 5 ou 6 maillons sur lequel peuvent être condensés un ou deux groupes benzo.

6. Procédé selon la revendication 5, dans lequel
R¹ est un groupe alkyle en C₁-C₄, trifluorométhyle, phényle, chlorophényle, dichlorophényle ou méthoxyphényle,
R² possède une des significations définies pour R¹, ou est un groupe cyano, au moins un des radicaux R¹ ou R² étant un groupe phényle ou phényle substitué, ou bien
R¹ et R² forment avec les atomes de carbone auxquels ils sont liés un système cyclique indane, fluorène, tétrahydronaphtalène, anthrone ou dihydroanthracène.

7. Procédé selon la revendication 3, dans lequel
n est 1 et
R³ est un groupe alkyle en C₁-C₁₈, aryle en C₆-C₁₀ qui peut être non substitué ou substitué par un atome d'halogène, un groupe alkyle en C₁-C₁₆, halogénoalkyle en C₁-C₄, aminoalkyle en C₁-C₄, alcoxy en C₁-C₄, (alkyle en C₁-C₄)carbonyle, (alkyle en C₁-C₄)carbonyloxy, benzoyle, benzoyloxy, hydroxyle, carboxyle, (alcoxy en C₁-C₄)carbonyle, (alkyle en C₁-C₄)-CONH-, phényle-CONH-, H₂N-, (alkyle en C₁-C₄)-NH-, di-(alkyle en C₁-C₄)-N- ou nitro, ou désigne un groupe cycloalkyle en C₅-C₁₂, aralkyle en C₇-C₉, trifluorométhyle ou trichlorométhyle, ou dans lequel
n est 2 et
R³ désigne un groupe alkylène en C₂-C₁₂, arylène en C₆-C₁₅ ou aralkylène en C₇-C₁₂, chacun de ces groupes pouvant être substitué par un groupe alkyle en C₁-C₁₆, un atome d'halogène ou un groupe hydroxyle, ou interrompu par -O-, -S- ou -NR⁵-, R⁵ désignant un atome d'hydrogène, un groupe alkyle en C₁-C₁₂ ou cycloheryle.

8. Procédé selon la revendication 7, dans lequel n est 1 et R³ est un groupe alkyle en C₁-C₁₂ ou désigne un groupe phényle qui est non substitué ou substitué par un atome d'halogène, un groupe alkyle en C₁-C₁₆ ou un groupe hydroxyle.

9. Procédé selon la revendication 3, dans lequel un des radicaux R¹ ou R² désigne un groupe phényle ou 4-méthoxyphényle, tandis que l'autre est un groupe cyano, ou dans lequel R¹ et R² forment avec l'atome de carbone auquel ils sont liés un système cyclique fluorène ou anthrone, R³ désigne un groupe 4-tolyle, 4-chlorophényle ou 4- dodécylphényle, m est 0 et n est 1.

10. Procédé selon la revendication 1, dans lequel la matière organique filmogène A) contient un groupe hydroxyle phénolique, un groupe carboxyle ou un groupe acide sulfonique.

11. Procédé selon la revendication 10, dans lequel la matière organique filmogène A) est un polymère à base d'un phénol à insaturation éthylénique, une résine novolaque ou un homopolymère ou copolymère à base d'un acide carboxylique à insaturation éthylénique ou d'un anhydrique d'acide carboxylique à insaturation éthylénique.

12. Composition qui convient pour l'exécution d'un procédé selon la revendication 1, contenant un mélange
A) d'une matière organique filmogène et
b) d'un composé photosensible ayant au moins un groupe sulfonate d'oxime répondant à la formule I et au moins un radical aromatique selon la revendication 1, ce composé B) ne contenant pas de groupe qui réagisse notablement avec le constituant A) et cette composition étant pratiquement exempte de matières qui, en combinaison avec B), se polymérisent par chauffage ou par irradiation avec un rayonnement actinique.

13. Composition selon la revendication 12, dans laquelle B) est un composé photosensible selon la revendication 2 et A) est une matière filmogène selon la revendication 10.

14. Composition selon la revendication 12, dans laquelle le sulfonate d'oxime B) est utilisé dans des quantités de 0,05 à 0,8 partie en poids pour une partie en poids de la matière organique filmogène A).
